# EUROPÄISCHE PATENTANMELDUNG

(11) **EP 3 961 367 A1**
(43) Veröffentlichungstag der Anmeldung: **02.03.2022**
(21) Anmeldenummer: 21184268.7
(22) Anmeldetag: 07.07.2021
(51) Int. Cl.: G06F 3/12

(54) **DIGITALE ERMITTLUNG PASSENDER DRUCKEREIEN**

(30) Priorität: 28.08.2020 DE 102020122548
(71) Anmelder: Heidelberger Druckmaschinen AG, 69115 Heidelberg (DE)
(72) Erfinder: Rößler, Georg, 74918 Angelbachtal (DE); Stahl, Dominic, 69256 Mauer (DE); Wagensommer, Bernhard, 69254 Malsch (DE); Grasl, Gottfried, 74918 Angelbachtal (DE)

(57) **Zusammenfassung**

Die Erfindung betrifft ein Verfahren zur Herstellung von Druckprodukten mittels wenigstens eines Rechners (1) und wenigstens einer Druckmaschine (5) Weiterverarbeitungsmaschine (12), wobei der Rechner (1) und die Druckmaschine (5) oder Weiterverarbeitungsmaschine (12) über eine Netzwerkverbindung (4) verbunden sind, Die Erfindung zeichnet sich dadurch aus, dass in einem ersten Schritt ein von einem Kunden gewünschtes Druckprodukt mit auf dem Rechner (1) hinterlegten digitalen Modellen von Druckprodukten verglichen wird,
dass durch Vergleich der hinterlegten digitalen Modelle von Druckprodukten und des vom Kunden gewünschten Druckprodukts das am besten passende digitale Modell von Druckprodukten durch den Rechner (1) ausgewählt wird,
dass in einem zweiten Schritt digitale Modelle von Druckereibetrieben (11) mit dem ausgewählten digitalen Modell des Druckprodukts durch den Rechner (1) auf Kompatibilität geprüft werden und die als geeignet ausgewählten digitalen Modelle der Druckereibetriebe (11) durch den Rechner (1) mit hinterlegten Präferenzmodellen tatsächlich existierender Druckereibetriebe (11) verglichen werden und übereinstimmende Präferenzmodelle tatsächlich existierender Druckereibetriebe für die Produktion des von einem Kunden gewünschten Druckauftrags durch den Rechner (1) ausgewählt werden und dass nach Auswahl wenigstens eines als geeignet befundenen tatsächlichen Druckereibetriebs (11) durch einen Rechner (10) des Kunden der vom Kunden gewünschte Druckauftrag auf wenigstens einer Druckmaschine (5) oder Weiterverarbeitungsmaschine (12) der vom Kunden ausgewählten Druckerei (11) abgearbeitet wird.

## Beschreibung

Die vorliegende Erfindung betrifft ein Verfahren zur Herstellung von Druckprodukten mittels wenigstens eines Rechners und wenigstens einer Druckmaschine, wobei der Rechner und die Druckmaschine über eine Netzwerkverbindung miteinander verbunden sind.

Die vorliegende Erfindung befasst sich mit der Problematik, Druckaufträge und dazu passende Druckereien mit ihrem Maschinenpark bzw. umgekehrt zueinander zu bringen. Dieses Ziel ist mit den heutigen Verfahren und Methoden nur schwer erreichbar. Der aktuelle digitale Workflow in der Druckbranche und insbesondere bei den Druckereien ist darauf ausgerichtet, Druckaufträge als gegeben anzusehen, um die Möglichkeiten einer Druckerei daraufhin zu überprüfen, ob der Druckauftrag eines Kunden in der Druckerei abgearbeitet werden kann, wobei die Druckerei dann für den Druckauftrag einen Preis kalkuliert. Diese Vorgehensweise hat den großen Nachteil, dass zwangsläufig immer nur aus der Sicht des Druckauftrags eines Kunden der gesamte Druck- und Herstellungsprozess gesehen wird und somit die Druckerei z. B. keine Möglichkeit hat, ihre Maschinenauslastung durch Auswahl passender Druckaufträge zu erhöhen.

Es ist daher Aufgabe der vorliegenden Erfindung, ein Verfahren zur Herstellung von Druckprodukten zu schaffen, bei dem einer Druckerei möglichst viele zu ihr passende Druckaufträge zugeordnet werden und damit in der Druckerei auf dem Maschinenpark auch abgearbeitet werden können.

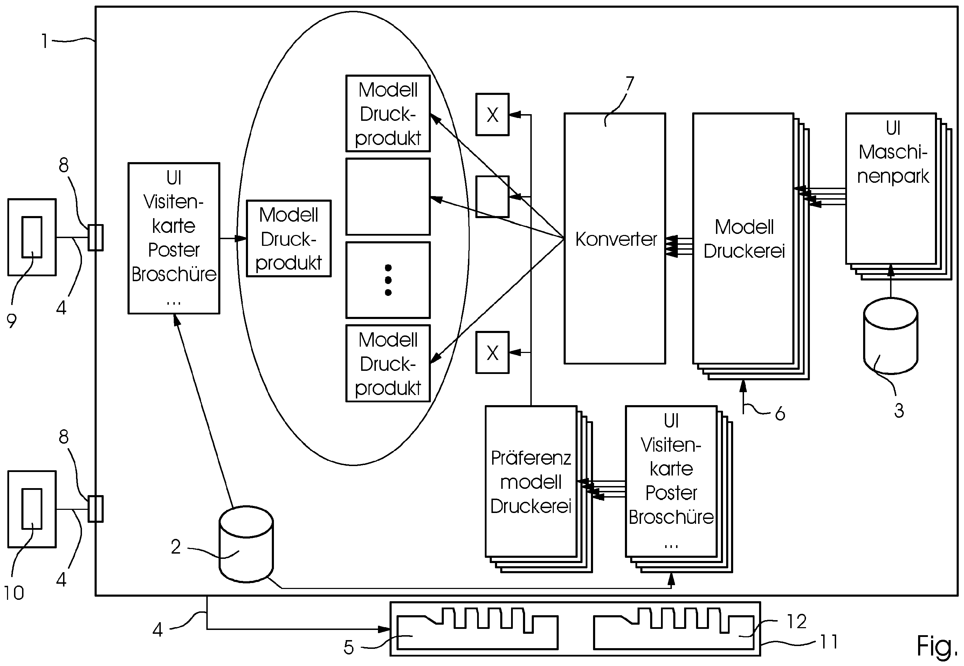

Diese Aufgabe wird erfindungsgemäß durch Patentanspruch 1 gelöst. Vorteilhafte Ausgestaltungen der vorliegenden Erfindung ergeben sich aus den abhängigen Patentansprüchen, der Beschreibung und der Zeichnung.

Im Mittelpunkt der vorliegenden Erfindung steht ein so genannter Konverter, welcher Modelle von Druckprodukten Modellen von Druckereien zuordnet und somit gewährleistet, dass einer Druckerei möglichst viele Druckaufträge zugeordnet werden können und keine Druckaufträge verlorengehen. Dementsprechend wird bei dem erfindungsgemäßen Verfahren in einem ersten Schritt ein von einem Kunden gewünschtes Druckprodukt mit auf einem Rechner hinterlegten digitalen Model von Druckprodukten verglichen. Im ersten Schritt wird also ein konkretes von einem Kunden in Auftrag gegebenes Druckprodukt mit modellierten digitalen Druckprodukten verglichen. Bei dem Vergleich der hinterlegten digitalen Modelle von Druckprodukten und des vom Kunden gewünschten Druckprodukts wird das am besten passende digitale Modell von Druckprodukten durch den Rechner automatisch ausgewählt, wobei die digitalen Modelle begrenzt sind und somit seltene Aufträge aussortiert werden. Bei diesen Vergleichen muss also weder der Druckereibetreiber noch der Kunde tätig werden, dies läuft automatisch auf einem Rechner ab.

Der zweite Schritt wird von der Seite der Druckereien aus angegangen, indem in dem zweiten Schritt digitale Modelle von Druckereibetrieben mit dem ausgewählten digitalen Modell des Druckprodukts durch den Rechner auf Komptabilität geprüft werden und die als geeignet ausgewählten digitalen Modelle der Druckereibetriebe durch den Rechner mit hinterlegten Präferenzmodellen tatsächlich existierender Druckereibetriebe verglichen werden. Somit werden zunächst alle zu dem digitalen Modell des Druckprodukts passenden digitalen Modelle von Druckereibetrieben in Beziehung gesetzt und die passenden digitalen Modelle der Druckereibetriebe auf dem Rechner abgespeichert. Die so als geeignet ausgewählten digitalen Modelle der Druckereibetriebe werden dann wiederum mit hinterlegten Präferenzmodellen tatsächlich existierender Druckereibetriebe verglichen, wobei übereinstimmende Präferenzmodelle tatsächlich existierender Druckereibetriebe für die Produktion des von dem Kunden gewünschten Druckauftrags durch den Rechner ausgewählt werden. In diesem Verfahrensschritt werden somit nun sämtliche tatsächlich existierende Druckereibetriebe bestimmt, auf denen ein vom Kunden gewünschtes Druckprodukt gefertigt werden kann. Von diesen tatsächlich existierenden Druckereibetrieben kann dann der Rechner wenigstens eine Druckerei auswählen, die dann den vom Kunden gewünschten Druckauftrag auf wenigstens einer Druckmaschine abarbeitet. Diese Auswahl geschieht entweder durch den Kunden direkt, indem dieser eine konkrete als geeignet befundene tatsächliche Druckerei auswählt, oder der Kunde hat wiederum gewissen Präferenzen, wie z. B. besonders niedrige Kosten oder schnelle Produktion hinterlegt, nach denen der Rechner dann den tatsächlichen Druckereibetrieb auswählt und die Abarbeitung des Druckauftrags beginnt.

Das erfindungsgemäße Verfahren zur Herstellung von Druckprodukten setzt voraus, dass die teilnehmenden Druckereien, der Rechner zur Abarbeitung der Verfahrensschritte und der Kunde mit dem Druckprodukt über ein Datennetzwerk wie das Internet miteinander verbunden sind und kommunizieren. Der Rechner und die erfindungsgemäßen Verfahrensschritte können dabei im Internet verteilt im Rahmen einer Cloud Computing Lösung ablaufen. Selbstverständlich kann der Rechner aber auch in einem zentralen Ort angeordnet sein und mit den anderen Teilnehmern ebenfalls über das Internet kommunizieren. Durch das erfindungsgemäße Verfahren wird sichergestellt, dass Kundenaufträge und Druckereien unter Berücksichtigung der Komptabilität von Druckereien und Druckaufträgen optimal zusammenfinden, indem alle möglichen Paarungen von Druckaufträgen und Druckereien berücksichtigt werden. Die dabei vorkommenden Unschärfen können dabei durch Toleranzgrenzen, welche in den digitalen Modellen des Druckprodukts und in den digitalen Modellen der Druckereien hinterlegt sind, berücksichtigt werden.

Bei der ersten Ausgestaltung der vorliegenden Erfindung ist vorgesehen, dass der Rechner Zugriff auf eine Datenbank mit vom Kunden auswählbaren Druckprodukten hat. Diese Datenbank kann Teil des Rechners sein, sie kann sich aber auch an einem beliebigen anderen Ort befinden, welcher über eine Internetverbindung mit dem Rechner verbunden ist. Die Datenbank enthält dabei vom Kunden auswählbare Druckprodukte, so dass der Kunde nicht völlig frei in der Auswahl der Druckprodukte ist, sondern vielmehr von vornherein auf sinnvolle Druckprodukte begrenzt ist. Dies macht das Zusammenfinden von Druckaufträgen und Druckereien wesentlich leichter. Insbesondere können auf diese Art und Weise sogenannte exotische Druckaufträge vermieden werden, da der Kunde seine Druckaufträge nicht völlig frei konfigurieren kann. Diese vom Kunden auswählbaren Druckprodukte können dabei insbesondere in Form von Templates mit bestimmten Parametern und Parameterbereichen hinterlegt sein.

In einer weiteren Ausgestaltung der vorliegenden Erfindung ist vorgesehen, dass das digitale Modell einer Druckerei Zugriff auf eine Datenbank mit hinterlegten digitalen Maschinendaten von Druckmaschinen und anderen Maschinen der Druckindustrie hat. Bei der Erstellung der digitalen Modelle einer Druckerei macht es keinen Sinn, digitale Modelle zu erstellen, welche durch real existierende Maschinen nicht nachgebildet werden können. Insofern ist es von Vorteil, dass das digitale Modell einer Druckerei nur Maschinen enthält, welche in der Realität auch existieren. Dazu basiert das digitale Modell einer Druckerei auf Maschinendaten von tatsächlich existierenden Druckmaschinen der am Markt agierenden Hersteller, wobei diese in Form einer Datenbank hinterlegt sind. Auch hier kann die Datenbank wiederum Teil des Rechners sein, sie kann aber auch separat über das Internet angebunden sein und sich gegebenenfalls auch am selben Ort wie die Datenbank mit den vom Kunden auswählbaren Druckprodukten befinden.

Vorteilhafterweise ist außerdem vorgesehen, dass die Datenbank für Druckprodukte mit digitalen Daten von Druckprodukten aus Druckereien gefüllt wird. In diesem Fall wird die Datenbank der Druckprodukte nur mit digitalen Daten von Druckaufträgen gefüllt, welche tatsächlich existierende Druckereien auch abarbeiten wollen. Die Druckereien übermitteln nur die Druckprodukte an die Datenbank, die sie als Druckaufträge bereit sind anzunehmen. Der Kunde hat in diesem Fall nicht die Möglichkeit, exotische Druckaufträge auszuwählen, welche die beteiligten Druckereien aus wirtschaftlichen oder technischen Gründen nicht in der Lage sind, sinnvoll abzuarbeiten. Auch diese Ausgestaltung der vorliegenden Erfindung dient in erster Linie dazu, unsinnige Druckaufträge von vorneherein aus dem Verkehr zu ziehen.

In einer weiteren Ausgestaltung der vorliegenden Erfindung ist vorgesehen, dass an den Rechner angeschlossene Druckereien über eine Netzwerkverbindung digitale Präferenzmodelle übertragen. Die digitalen Präferenzmodelle der Druckerei enthalten Daten über Druckaufträge, welche diese Druckereien abarbeiten können und möchten. Damit können die Druckereien aufgrund ihrer z.B. wirtschaftlichen Präferenzen Druckaufträge von vornherein ausschließen, welche sie auf ihrem Maschinenpark zwar abarbeiten könnten, aber z.B. aus wirtschaftlichen Gründen nicht abarbeiten wollen. Auf diese Art und Weise können Druckereien nicht genehme Modelle von Druckprodukten bei der Konvertierung unberücksichtigt lassen. Die Druckereien können dabei ihre digitalen Präferenzen ebenfalls über das Internet an den Rechner übertragen. Vorteilhafterweise ist außerdem vorgesehen, dass Hersteller von Druckmaschinen und anderen Maschinen in der Druckindustrie die digitalen Daten ihrer Maschinen an die Datenbank für Druckmaschinen übermitteln. Auf diese Art und Weise ist die Datenbank für Druckmaschinen immer mit den aktuellen und tatsächlich verfügbaren Druckmaschinen und anderen Maschinen in der Druckindustrie belegt, so dass sichergestellt wird, dass der aktuell und tatsächlich verfügbare Maschinenpark bei der Erstellung eines digitalen Modells einer Druckerei berücksichtigt und verwendet wird, so dass später bei der Abarbeitung der Druckaufträge auf den real existierenden Maschinen keine Kompatibilitätsprobleme auftauchen.

In einer weiteren Ausgestaltung der vorliegenden Erfindung ist vorgesehen, dass das digitale Modell des Druckprodukts Angaben wie Produkttyp, Seitengrößen, Farben, Veredelung, Papieroberfläche, Grammatur, Seitenanzahl oder einen Gang zur Weiterverarbeitung enthält. Mit den vorgenommenen technischen Angaben lässt sich das digitale Modell des Druckprodukts ziemlich genau und realitätsnah abbilden, so dass alle notwendigen, für die Herstellung des Druckprodukts erforderlichen Produktionsgänge auch im Modell berücksichtigt werden. Nur dann kann der Konverter durch die Abbildung der Eigenschaften der digitalen Druckereimodelle auf die digitalen Modelle der Druckprodukte auch tatsächlich zueinander passende Druckprodukte und Druckereien ermitteln, so dass diese dann auch in der Realität problemlos abgearbeitet werden können.

Des Weiteren ist vorgesehen, dass der Rechner über Schnittstellen verfügt, über welche mittels Internetverbindung Rechner in real existierenden Druckereibetrieben oder bei Brokern und Rechner- oder Browseranwendungen von Kunden der Druckereibetriebe angebunden werden. Über diese Internet-Schnittstellen und -Verbindung können die real existierenden Druckereibetriebe oder Broker und die Kunden mit den Druckaufträgen in das erfindungsgemäße Verfahren integriert werden, um so Druckaufträge und Druckereibetriebe optimal zueinander bringen zu können. Aufgrund der Internetschnittstellen kann diese Einbindung über jedes internetfähige Gerät durch Verwendung eines Browserportals problemlos verwirklicht werden. Es ist daher nicht erforderlich, dass ein Druckereibetrieb oder ein Kunde zunächst eine Software in Form eines Programms oder einer App installiert, sondern der Kunde kann direkt über einen Internetbrowser und einen Zugang mit Benutzernamen und Passwort Zugang zu dem erfindungsgemäßen Verfahren finden und von dessen Vorteilen profitieren.

Die vorliegende Erfindung wird nachfolgend anhand einer Figur näher beschrieben und erläutert. Die Figur zeigt:
die am erfindungsgemäßen Verfahren beteiligten Komponenten am Beispiel eines Kunden und einer Druckerei.

Gemäß der Figur steht im Mittelpunkt ein Rechner 1, welcher mittels Software das erfindungsgemäße Verfahren abarbeitet. Der Rechner 1 kann dabei zentral oder dezentral angeordnet sein, insbesondere kann er Bestandteil einer Cloud Computing Lösung sein. In jedem Fall verfügt der Rechner 1 über Hardware- und/oder Softwareschnittstellen 8, mit denen der Rechner 1 über Internetverbindungen 4 mit allen Beteiligten an dem erfindungsgemäßen Verfahren kommunizieren kann. Auf diese Art und Weise steht der Rechner 1 mit dem Rechner 9 eines Brokers, mit dem Rechner 10 eines Kunden und mit der Druckmaschine 5 und Falzmaschine 12 einer Druckerei 11 in Verbindung.

Im Mittelpunkt des erfindungsgemäßen Verfahrens stehen die Vorgänge und Verfahrensschritte, welche in der Figur innerhalb des Rechners 1 abgebildet sind. So hat der Rechner 1 Zugriff auf eine Datenbank 2 für Druckprodukte und auch auf eine Datenbank 3 für Druckmaschinen und weitere Maschinen der Druckindustrie. In der Datenbank 2 für Druckprodukte befinden sich alle möglichen, in der Realität vorkommenden Druckprodukte, welche sich in sinnvollen Templates abbilden lassen. Dies bedeutet wiederum, dass die Datenbank 2 für Druckprodukte natürlich keine Einzelanfertigungen enthält, wenn diese nicht regelmäßig abgerufen werden. Aus dieser Datenbank 2 für Druckprodukte kann ein Kunde über den Rechner 10 das für ihn passende Druckprodukt auswählen.

Auf der anderen Seite des Konverters 7 befinden sich die digitalen Modelle von Druckereien 11, welche z.B. über digitale Daten aus einem ERP-System 6, wie z.B. SAP, erstellt werden. Weiterhin kann der Maschinenpark real existierender Druckereien 11 über die Datenbank 3 für Druckmaschinen erstellt werden, indem die in der Datenbank 3 abgespeicherten Maschinen herangezogen werden. Auf diese Art und Weise können digitale Modelle von Druckereien 11 erstellt werden. Weiterhin können die Druckereien 11 sogenannte Präferenzmodelle angeben, d.h. sie geben Präferenzen für bestimmte Druckaufträge an und schließen z.B. ungewünschte Druckaufträge aus. Diese Präferenzen verhindern, dass Druckereien 11 Druckaufträge zugewiesen werden, welche diese zwar möglicherweise technisch gesehen abarbeiten könnten, welche aber wirtschaftlich keinen Sinn machen.

Nachdem der Kunde über seinen Rechner 10 einen Druckauftrag ausgewählt hat, wird dieser im Rechner 1 mit digitalen Modellen von Druckprodukten verglichen. Aufgrund der hinterlegten Präferenzmodelle der Druckereien 11 wird der Druckauftrag des Kunden nur mit solchen digitalen Modellen hinterlegt, welche zu den Präferenzen der Druckereien 11 auch passen. Je nach Präferenzmodellen und digitalen Modellen zu Druckprodukten sowie dem vom Kunden gewünschten Druckprodukt gibt es keine, eine oder mehrere Übereinstimmungen. Alle übereinstimmenden digitalen Modelle von Druckprodukten können dann vom Kunden auf seinem Rechner 10 ausgewählt werden.

Die Abbildung von digitalen Druckprodukten auf die digitalen Modelle von Druckereien 11 erfolgt dabei über den Konverter 7, wobei die hinterlegten Präferenzen der Druckereien 11 berücksichtigt werden. Dabei werden die Eigenschaften der digitalen Druckprodukte unter Anwendung der Präferenzen mit den digitalen Eigenschaften der digitalen Modelle der Druckereien 11 verglichen und nur übereinstimmende digitale Modelle von Druckprodukten ausgewählt. Am Ende kann der Kunde 10 über seinen Rechner die entsprechende Druckerei selbst auswählen, so dass sein Druckauftrag dann zur Druckmaschine 5 der ausgewählten Druckerei zur Abarbeitung gesendet wird. Der Konverter 7 nimmt die Abbildung der digitalen Modelle von Druckprodukten auf die digitalen Modelle der Druckereien 11 anhand der Eigenschaften von Druckaufträgen und Druckmaschinen 5 und Weiterverarbeitungsmaschinen wie Falzmaschinen 12 vor. Dabei werden z.B. die Seitengröße und das Drucksubstrat des Druckauftrags berücksichtigt, welche in einer 1:1-Logik abgebildet werden. Bei Farben, Lack, Falzschemata und anderen komplizierten Eigenschaften von Druckaufträgen, kommt im Konverter 7 eine komplexe Abbildungslogik zum Einsatz. So werden die Farben zunächst in sogenannte Skalen und Sonderfarben aufgeteilt, welche dann auf die Anzahl von Druckwerken in einer Druckmaschine 5 abgebildet werden. Auch die Position der Wendeeinrichtung von Druckmaschinen 5 für Schön- und Widerdruck wird hierbei berücksichtigt. Beim Lackieren wird zwischen dem lackierenden Druckwerk und dem vollflächigen Lackieren im Lackwerk unterschieden. Auch die Falzschemata für Falzmaschinen 12 werden auf die Konfiguration der jeweiligen Falzmaschine 12 abgebildet. Die Falzschemata wiederum lassen sich aus der Position der Wendeeinrichtung und der Anzahl der Druckwerke direkt ableiten. Es ist zu erkennen, dass der Konverter 7 somit die digitalen Modelle der Druckaufträge und die digitalen Modelle der Druckmaschinen 5 und Weiterverarbeitungsmaschinen zueinander bringt und ineinander umrechnet und somit mögliche digitale Modelle von Druckaufträgen bestätigen kann, welche auf den digitalen Modellen von Druckereien 11 auch tatsächlich abgearbeitet werden können.

Weiterhin ist es auch möglich, dass der Kunde 10 bereits Vorgaben, z.B. Auswahl der günstigsten Druckerei 11, hinterlassen hat, so dass der Rechner 1 dann selbsttätig die günstigste Druckerei 11 auswählen kann und den Druckauftrag automatisch zur Druckmaschine 5 dieser Druckerei 11 schickt. Dazu ist auch die Kostenstruktur in dem digitalen Modell der Druckerei 11 enthalten. Auf diese Art und Weise wird es möglich, Druckaufträge von Kunden und Druckereien auf optimale Art und Weise zueinander zu bringen, wobei am Ende der Kunde die Möglichkeit hat, gemäß seiner Präferenzen aus den in Frage kommenden Druckereien 11 auszuwählen. Auf diese Art und Weise wird eine vollautomatische Auftragsabwicklung zwischen Kunde und Druckerei 11 ermöglicht.

### Bezugszeichenliste

- 1: Rechner
- 2: Datenbank für Druckprodukte
- 3: Datenbank für Maschinen
- 4: Internetverbindung
- 5: Druckmaschine
- 6: ERP-System
- 7: Konverter
- 8: Schnittstelle
- 9: Rechner des Brokers
- 10: Rechner des Kunden
- 11: Druckerei
- 12: Falzmaschine

## Patentansprüche

1. Verfahren zur Herstellung von Druckprodukten mittels wenigstens eines Rechners (1) und wenigstens einer Druckmaschine (5) oder Weiterverarbeitungsmaschine (12), wobei der Rechner (1) und die Druckmaschine (5) oder Weiterverarbeitungsmaschine (12) über eine Netzwerkverbindung (4) verbunden sind,
**dadurch gekennzeichnet,**
**dass** in einem ersten Schritt ein von einem Kunden gewünschtes Druckprodukt mit auf dem Rechner (1) hinterlegten digitalen Modellen von Druckprodukten verglichen wird,
**dass** durch Vergleich der hinterlegten digitalen Modelle von Druckprodukten und des vom Kunden gewünschten Druckprodukts das am besten passende digitale Modell von Druckprodukten durch den Rechner (1) ausgewählt wird,
**dass** in einem zweiten Schritt digitale Modelle von Druckereibetrieben (11) mit dem ausgewählten digitalen Modell des Druckprodukts durch den Rechner (1) auf Kompatibilität geprüft werden und die als geeignet ausgewählten digitalen Modelle der Druckereibetriebe (11) durch den Rechner (1) mit hinterlegten Präferenzmodellen tatsächlich existierender Druckereibetriebe (11) verglichen werden und übereinstimmende Präferenzmodelle tatsächlich existierender Druckereibetriebe (11) für die Produktion des von einem Kunden gewünschten Druckauftrags durch den Rechner (1) ausgewählt werden und dass nach Auswahl wenigstens eines als geeignet befundenen tatsächlichen Druckereibetriebs (11) durch einen Rechner (10) des Kunden der vom Kunden gewünschte Druckauftrag auf wenigstens einer Druckmaschine (5) oder Weiterverarbeitungsmaschine (12) der vom Kunden ausgewählten Druckerei (11) abgearbeitet wird.

2. Verfahren nach Anspruch 1,
**dadurch gekennzeichnet,**
**dass** der Rechner (1) Zugriff auf eine Datenbank (2) mit vom Kunden auswählbaren Druckprodukten hat.

3. Verfahren nach einem der vorhergehenden Ansprüche,
**dadurch gekennzeichnet,**
**dass** das digitale Modell einer Druckerei Zugriff auf eine Datenbank (3) mit hinterlegten digitalen Maschinendaten von Druckmaschinen (5) und anderen (12) Maschinen der Druckindustrie hat.

4. Verfahren nach Anspruch 2 oder 3,
**dadurch gekennzeichnet,**
**dass** die Datenbank (2) für Druckprodukte mit digitalen Daten von Druckprodukten aus Druckereien (11) gefüllt wird.

5. Verfahren nach einem der vorhergehenden Ansprüche,
**dadurch gekennzeichnet,**
**dass** an den Rechner (1) angeschlossene Druckereien über eine Netzwerkverbindung (4) digitale Präferenzmodelle übertragen.

6. Verfahren nach einem der vorhergehenden Ansprüche,
**dadurch gekennzeichnet,**
**dass** der Rechner (1) in einer Cloud-Software-Lösung verwirklicht ist und mit den teilnehmenden Druckereibetrieben (11) über eine Internetverbindung (4) verbunden ist.

7. Verfahren nach einem der vorhergehenden Ansprüche,
**dadurch gekennzeichnet,**
**dass** Hersteller von Druckmaschinen (5) und anderen Maschinen in der Druckindustrie (12) die digitalen Daten ihrer Maschinen (5) an die Datenbank (3) für Druckmaschinen übermitteln.

8. Verfahren nach einem der vorhergehenden Ansprüche,
**dadurch gekennzeichnet,**
**dass** das digitale Modell des Druckprodukts Angaben wie Produkttyp, Seitengrößen, Farben, Veredelung, Papieroberfläche, Grammatur, Seitenanzahl oder einen Gang zur Weiterverarbeitung enthält.

9. Verfahren nach einem der vorhergehenden Ansprüche,
**dadurch gekennzeichnet,**
**dass** die Eigenschaften der digitalen Druckereimodelle mittels eines Konverters (7) auf die digitalen Modelle der Druckprodukte abgebildet werden.

10. Verfahren nach einem der vorhergehenden Ansprüche,
**dadurch gekennzeichnet,**
**dass** der Rechner (1) über Schnittstellen (8) verfügt, über welche mittels Internetverbindung (4) Rechner (9) in real existierende Druckereibetrieben (11) oder Brokern und Rechner (10) oder Browser Anwendungen von Kunden der Druckereibetriebe (11) angebunden werden.
